## Europäisches Patentamt
## European Patent Office
## Office européen des brevets

(11) Numéro de publication: **0 178 209**
**B1**

(12) # FASCICULE DE BREVET EUROPEEN

(45) Date de publication du fascicule du brevet:
**11.04.90**

(51) Int. Cl.⁴: **G01R 19/165**

(21) Numéro de dépôt: **85401797.7**

(22) Date de dépôt: **17.09.85**

(54) **Détecteur de niveau de signal analogique.**

(30) Priorité: **21.09.84 FR 8414567**

(43) Date de publication de la demande:
**16.04.86 Bulletin 86/16**

(45) Mention de la délivrance du brevet:
**11.04.90 Bulletin 90/15**

(84) Etats contractants désignés:
**DE FR GB IT NL**

(56) Documents cités:
**GB-A- 1 254 820**
**US-A- 4 200 863**
**US-A- 4 204 260**
**US-A- 4 429 185**

**IEEE JOURNAL OF SOLID-STATE CIRCUITS, vol. SC-10, no. 6, décembre 1975, pages 371-379, New York, US; J.L. McCREARY et al.: "All-MOS charge redistribution analog-to-digital conversion techniques - Part I"**
**ELECTRONIC DESIGN,**
**vol. 28, no. 2, janvier 1980, page 118, Rochelle Park, US; N. BHASKARA RAO: "Counter and DAC replace analog integrator in delta-modulation scheme"**
**IBM TECHNICAL DISCLOSURE BULLETIN, vol. 25, no. 10, mars 1983, pages 4966, 4967, New York,**

(73) Titulaire: **SGS-THOMSON MICROELECTRONICS S.A., 7, Avenue Galliéni, F-94250 Gentilly(FR)**

(72) Inventeur: **Tallaron, Louis, THOMSON-CSF SCPI 173, bld Haussmann, F-75379 Paris Cedex 08(FR)**
Inventeur: **Bertails, Jean-Claude, THOMSON-CSF SCPI 173, bld Haussmann, F-75379 Paris Cedex 08(FR)**

(74) Mandataire: **Rinuy, Santarelli, 14, avenue de la Grande Armée, F-75017 Paris(FR)**

(56) Documents cités: (suite)
**US; D.E. CONNER et al.: "Incremental over-current fault detector circuit"**

## Description

La présente invention concerne un détecteur de niveau de signal analogique.

Le terme niveau sera pris ici dans un sens très large, car les applications que l'on envisage pour ce détecteur sont des applications dans lesquelles on cherche essentiellement à savoir si un signal attendu est présent ou absent. Ce signal est attendu, c'est-à-dire qu'on connaît à peu près l'étendue de son spectre de fréquences et son amplitude approximative, même si la gamme de possibilités est relativement large.

Par exemple, un modem (modulateur-démodulateur) connecté à une ligne téléphonique devra reconnaître la présence d'un signal d'appel constitué par une porteuse de fréquence connue.

On peut envisager d'autres applications analogues ou même assez différentes: un détecteur d'activité vocale dans un analyseur de parole pourra être utile pour ne déclencher les opérations d'analyse qu'en présence d'un signal qui manifeste l'existence établie d'une activité vocale de niveau suffisant.

Par conséquent, le détecteur de niveau dont il s'agit peut être un détecteur de niveau moyen du signal redressé, sans que le mot moyen doive être pris dans un sens strict du point de vue mathématique; le but est de délivrer un signal de reconnaissance de la présence d'un signal d'entrée si cette valeur moyenne dépasse un seuil déterminé.

On conçoit qu'une telle détection nécessite un filtrage passe-bas, c'est-à-dire une certain intégration de signal, avec une constante de temps largement supérieure à la période de variation du signal reçu; sans cela on risquerait de détecter alternativement la présence et l'absence du signal à chaque crête et chaque creux du signal alternatif redressé.

Ainsi donc, il est nécessaire d'une part de redresser (redressement de préférence double alternance) le signal à détecter, et d'autre part de lui faire subir une certaine intégration.

Malheureusement, l'intégration d'un signal analogique avec une constante de temps assez longue (par exemple 200 millisecondes pour un signal à 50 hertz) nécessite des capacités de valeur relativement importantes, ce qui exclut ou rend difficile une réalisation du détecteur de signal sous forme de circuit intégré; pour un modem par exemple, on souhaite non seulement que le détecteur soit réalisé sous forme intégrée, mais en plus on veut qu'il fasse partie de la même puce semi-conductrice que le modem lui-même.

La présente invention propose d'utiliser un détecteur de niveau de signal analogique qui est particulièrement simple et ne nécessite pas de capacité de valeur importante. Ce détecteur présente la particularité d'utiliser comme élément d'intégration un compteur-décompteur numérique, le compteur exécutant soit un comptage soit un décomptage en fonction d'une comparaison de type analogique entre le signal dont le niveau est à détecter et un signal de type analogique représentant le contenu de compteur. Le dépassement du niveau à détecter est déterminé à partir du contenu du compteur.

Dans le plus simple des cas, le bit de poids fort du compteur peut servir à définir s'il y a dépassement d'un niveau moyen déterminé.

La fréquence de comptage est fixe et choisie telle que le contenu du compteur oscille autour d'un niveau moyen avec une amplitude d'oscillation faible devant ce niveau; le contenu du compteur est alors une représentation du niveau moyen du signal d'entrée.

Plus précisément, on propose d'utiliser un détecteur de niveau qui comprend :
- un compteur/décompteur, dont les sorties fournissent une indication numérique du niveau du signal analogique d'entrée,
- un comparateur analogique dont la sortie est reliée à une entrée de sens de comptage du compteur, le sens du comptage étant déterminé par l'état de la sortie du comparateur,
- un moyen d'établissement d'un signal d'écart, ce moyen étant relié aux sorties du compteur/décompteur et recevant par ailleurs le signal d'entrée à détecter, pour établir et appliquer à l'entrée du comparateur un signal d'écart représentant la différence entre le niveau de tension du signal analogique à détecter et une quantité proportionnelle au contenu du compteur,
- et un moyen d'établissement d'une fréquence de comptage pour le compteur, cette fréquence étant telle que la durée de croissance du contenu du compteur de zéro à sa valeur maximale soit largement supérieure à la période moyenne du signal à détecter. En d'autres mots, on établit un signal d'écart dont le signe positif ou négatif est détecté par le comparateur; si ce signe est positif, le compteur va compter; s'il est négatif, le compteur va décompter; dans les deux cas le contenu du compteur va varier, lentement, dans un sens tendant à réduire l'amplitude du signal d'écart. Le compteur agit comme intégrateur du signe de l'écart entre son propre contenu et le signal à détecter. Par cette intégration, en présence d'un signal d'entrée stable, le contenu du compteur va subir des alternances de périodes de croissance et de périodes de décroissance de telle sorte qu'en moyenne le signe du signal d'écart soit aussi souvent positif que négatif. Pour un signal d'entrée constitué par une sinusoïde redressée double alternance, on peut vérifier que le contenu du compteur oscille alors autour d'un niveau que représente la valeur efficace du signal d'entrée.

Dans le cas le plus général, il est nécessaire de prévoir un redresseur (de préférence double alternance) en amont de l'entrée du détecteur si le signal analogique d'entrée à détecter est alternatif. Toutefois, on montrera comment, dans un mode d'exécution préférentiel de l'invention, le redresseur peut être supprimé, à condition de prendre en compte le signe du signal d'entrée à la fois pour l'établissement du signal d'écart et pour la détermination du sens de comptage.

Dans un mode d'exécution simple mais nécessitant un redresseur en amont du détecteur proprement dit, le moyen d'établissement du signal d'écart comprend un convertisseur numérique/analogique relié aux sorties du compteur. La sortie du convertisseur est appliquée à une entrée du comparateur qui reçoit par ailleurs sur une autre entrée le signal d'entrée redressé.

Un détecteur du type susmentionné est connu du brevet US-A 4 204 260.

Pour s'affranchir de l'inconvénient selon lequel un redresseur est prévu en amont du détecteur, la présente invention prévoit que le moyen d'établissement du signal d'écart comporte un ensemble de capacités commutées ayant des valeurs respectives pondérées selon les mêmes poids binaires que les sorties du compteur utilisées pour définir le signal d'écart. Une source de tension de référence définit le rapport entre le contenu du compteur et la quantité servant à définir le signal d'écart (c'est-à-dire la quantité comparée au signal analogique d'entrée). Un circuit de commande de commutation établit des signaux de commande de commutation selon un cycle périodique à plusieurs phases, à la fréquence de comptage du compteur. Enfin, un circuit logique d'aiguillages, commandé par les sorties du compteur et par le circuit de commande de commutation, permet d'appliquer individuellement à chaque capacité commutée soit le signal d'entrée, soit la tension de référence, soit encore potentiel de masse, selon des conditions qui seront définies plus loin. Les capacités commutées sont reliées à l'entrée du comparateur et établissent périodiquement sur cette entrée, à la fréquence de comptage du compteur, un potentiel qui est le signal d'écart mentionné ci-dessus. Ce potentiel est comparé à zéro par le comparateur pour définir le sens de comptage du compteur.

Le cycle de commutation est en principe le suivant :
- dans une phase de précharge, les capacités sont toutes chargées avec le signal d'entrée à détecter; puis, les charges stockées sont isolées; une première armature de chaque capacité est reliée à l'entrée du comparateur en restant maintenue en haute impédance vis-à-vis de toute source de courant continu;
- dans une phase de comparaison, le potentiel de référence ou un potentiel de masse est appliqué à la seconde armature de chaque capacité, le choix du potentiel appliqué à une capacité déterminée étant fixé par l'état de celle des sorties du compteur qui correspond au même poids binaire que la capacité considérée; le signal d'écart apparaît alors à l'entrée du comparateur et est comparé à zéro.

Selon la présente invention on supprime la nécessité d'un redresseur en amont de l'entrée du détecteur, même pour un signal d'entrée alternatif, en introduisant à chaque période une phase de commutation supplémentaire qui est une phase de détermination du signe du signal d'entrée. Dans cette phase, située en principe entre la phase de précharge et la phase de lecture, on applique à la seconde armature de toutes les capacités un potentiel de masse, de sorte que pendant cette phase la sortie du comparateur bascule dans un sens ou dans un autre selon le signe de la tension d'entrée. Ce signe est mémorisé dans une bascule et sert, s'il est négatif, à modifier le mode d'établissement du signal d'écart et le sens de comptage du compteur.

Par exemple, on peut prévoir que le signe détecté et mémorisé est négatif, on remplace la source de tension de référence (positive) par une source de tension de référence négative de même valeur; en même temps, le sens de comptage déterminé par la sortie du comparateur après la phase de lecture est inversé par rapport à ce qu'il serait pour un signe positif du signal d'entrée (une porte OU-exclusif commandée par la bascule de mémorisation du signe est alors intercalée entre la sortie du comparateur et l'entrée de sens de comptage du compteur).

Dans une autre réalisation, pour éviter de prévoir une source de tension de référence négative, on prévoit plutôt une capacité supplémentaire, de valeur égale à la somme des valeurs des autres; cette capacité est préchargée à la tension de référence pendant la phase de précharge; on lui applique ensuite, pendant la phase de lecture, soit encore cette tension de référence soit le potentiel de masse selon que le signe mémorisé est positif ou négatif. En même temps, si le signe mémorisé est négatif, on inverse le choix entre le potentiel de référence et le potentiel de masse appliqués aux capacités commutées pendant la phase de lecture; ces deux modification reviennent à établir un signal d'écart qui n'est pas la différence entre le signal d'entrée et la quantité proportionnelle au contenu du compteur mais la différence entre l'inverse du signal d'entrée et cette quantité; un pseudo-redressement double alternance est donc effectué; il reste alors encore à inverser le sens du comptage lorsque le signe du signal d'entrée est négatif, comme on le comprendra dans les explications qui suivent.

D'autres caractéristiques et avantages de l'invention apparaîtront à la lecture de la description détaillée qui suit et qui est faite en référence aux dessins annexés dans lesquels;
- la figure 1 représente le circuit de base auquel s'applique l'invention,
- la figure 2 représente un diagramme temporel utile à la compréhension du fonctionnement du schéma de la figure 1,
- la figure 3 représente un mode d'exécution préférentiel de l'invention,
- la figure 4 représente un diagramme temporel des signaux de commande de commutation utilisés dans le circuit de la figure 3.

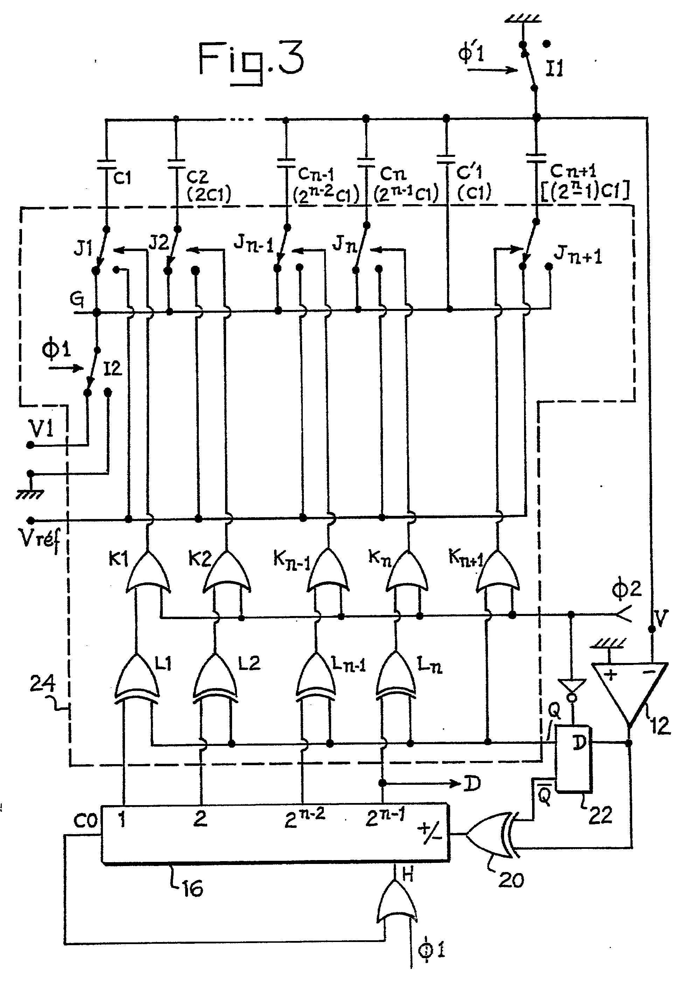

La figure 1 représente un mode de réalisation simple d'un détecteur. Dans cette réalisation, il est nécessaire de prévoir un redresseur 10, de préférence double alternance, en amont de l'entrée du détecteur, si le signal analogique VI dont le niveau est à détecter est alternatif.

L'entrée A du redresseur 10, reçoit ce signal VI.

La sortie B du redresseur fournit un signal redressé V2. A la figure 2, on a représenté pour simplifier le signal d'entrée VI comme une sinusoïde de fréquence F, le signal V2 comportant donc des alternances positives successives.

La sortie B du redresseur est reliée à une entrée d'un comparateur 12 ayant une autre entrée C reliée à la sortie d'un convertisseur numérique/analogique 14. Ce convertisseur a ses entrées reliées aux sorties d'un compteur/décompteur 16 dont le comptage ou le décomptage s'effectue à une fréquence f définie par un signal d'horloge H. La sortie du convertisseur 14 établit sur l'entrée C une tension V3 qui représente les variations du contenu du compteur. Cette tension V3 varie en escalier selon des rampes alternativement croissantes (lorsque le compteur compte) et décroissantes (lorsque le compteur décompte), comme on le voit sur la figure 2.

Le circuit de la figure 1 établit ainsi un signal d'écart V4 qui est la différence entre les tensions V2 et V3 donc entre le signal d'entrée (redressé) et une quantité proportionnelle au contenu du compteur.

La sortie du comparateur 12 est reliée à une entrée de sens de comptage du compteur 16 et l'état de cette sortie détermine le sens de comptage du compteur: si V2 est supérieur à V3, le compteur 16 va compter; si V2 est inférieur à V3, le compteur va décompter. Dans les deux cas, le sens de comptage est tel que la quantité V3 représentant le contenu du compteur va tendre à suivre le signal d'entrée redressé V2.

Toutefois, la pente maximale de croissance de la quantité V3 est volontairement limitée à une valeur telle qu'en réalité V3 ne puisse pas du tout suivre assez vite le signal V2.

Pour cela, on prévoit que la fréquence de comptage f définie par l'horloge H est telle que la durée mise par le signal V3 pour croître de zéro à son maximum (c'est-à-dire la durée mise par le compteur pour passer de zéro à son maximum) est largement supérieure à la période 1/F du signal d'entrée V1. Si le contenu maximum du compteur est Nmax, il faut que Nmax/f, soit largement supérieure à 1/F.

L'amplitude du signal V3 dépend de l'échelle de la conversion numérique/analogique dans le convertisseur 14. Une tension de référence Vréf sert à définir cette échelle par exemple, Vréf est le niveau atteint par V3 lorsque le contenu du compteur est à son maximum.

On a encore indiqué sur la figure 1 un deuxième signal d'horloge H' de même fréquence f que le signal H, pour commander périodiquement la conversion numérique/analogique.

Il faut cependant prendre garde à vérifier que les phases respectives des signaux H et H' sont telles que l'incrémentation ou la décrémentation du compteur ne se produise pas à un moment où le comparateur 12 bascule.

En présence d'un signal alternatif sinusoïdal V1 d'amplitude stable, on constate que le signal en escalier V3 va osciller faiblement autour d'une valeur moyenne. C'est cette valeur moyenne que le détecteur de la présente invention fournit à l'utilisateur. Pour un signal d'entrée sinusoïdal redressé en double alternance, cette valeur moyenne représente en fait la valeur efficace du signal d'entrée. Pour un signal alternatif quelconque, on peut tout simplement dire qu'en régime stable le signal en escalier oscille triangulairement (rampes croissantes et rampes décroissantes) et le niveau moyen de cette oscillation triangulaire s'établit à une valeur telle qu'en moyenne le signal redressé V2 soit aussi souvent supérieur qu'inférieur au signal en escalier V3.

Cette valeur moyenne peut être obtenu soit sous forme analogique en sortie du convertisseur 14, soit sous forme numérique en sortie du compteur 16 (sortie D). Dans un cas très simple, on n'utilise comme sortie du détecteur que le bit de poids fort du compteur: on choisit la valeur de la tension Vréf en fonction d'un seuil de niveau que l'on désire détecter et on s'arrange pour que la valeur du bit de poids fort du compteur définisse le dépassement ou le non dépassement de ce seuil. Un cas très simple est celui où le seuil choisi est Vréf/2 alors que le maximum du signal en escalier V3 est Vréf.

On peut encore préciser à propos de la figure 1 que seuls quelques bits de poids fort du compteur peuvent être utilisés pour être appliqué au convertisseur numérique/analogique: le signal en escalier V3 aura toujours la même pente mais aura moins d'échelons.

La figure 3 représente un exemple préférentiel de réalisation de l'invention, dans lequel le signal d'écart est établi par un ensemble de capacités commutées (C1 à $C_n$). Le circuit de la figure 3 comprend encore un compteur/décompteur 16 ayant une entrée de sens de comptage reliée, par l'intermédiaire d'une porte OU-exclusif 20, à la sortie d'un comparateur 12 dont une entrée est reliée à la masse et l'autre reçoit un signal d'écart (tension V) représentant la différence entre le signal d'entrée et une quantité proportionnelle au contenu du compteur. On verra comment ce signal d'écart est établi périodiquement par l'ensemble de capacités commutées. Dans ce mode de réalisation, la tension V est en réalité l'inverse du signal d'écart défini ci-dessus et elle est appliquée à l'entrée inverseuse du comparateur 12.

La sortie du comparateur 12 est reliée par ailleurs à l'entrée d'une bascule 22 de mémorisation du signe du signal d'entrée V1 à détecter. En effet, dans cette réalisation, le signal d'entrée V1 peut être alternatif autour du potentiel de masse, sans pour autant qu'il soit nécessaire de prévoir un redresseur double alternance. Le comparateur 12 détecte périodiquement (à la fréquence de comptage f) le signe de V1, et les sorties de la bascule 22 gardent en mémoire ce signe. Ici, la sortie Q de la bascule 22 est à 1 et la sortie $\overline{Q}$ à 0 si le signe est positif, et inversement si le signe est négatif.

La sortie $\overline{Q}$ de la bascule 22 est reliée à une entrée de la porte OU-exclusif 20 (dont l'autre entrée reçoit la sortie du comparateur 12), de sorte que si le signe détecté pendant une période de comptage est positif, l'entrée de sens de comptage du compteur prend un état qui est celui de la sortie du comparateur 12 (comptage si la tension V est négative, décomptage dans le cas contraire). Si au contraire le signe de V1 est négatif, la porte OU-exclusif 20 inverse l'instruction donnée par la sortie du comparateur (décomptage si la tension V est négative, comptage dans le cas contraire).

Les capacités C1 à $C_n$ ont toutes une première armature reliée à une entrée inverseuse (-) de l'amplificateur différentiel constituant le comparateur 12; l'autre entrée du comparateur, non inverseuse (+), est reliée à la masse.

L'autre armature de chaque capacité C1 à $C_n$ est reliée à une sortie respective d'un circuit logique d'aiguillage 24 qui reçoit comme signaux à aiguiller d'une part le signal d'entrée V1, d'autre part un potentiel de masse, et enfin un potentiel de référence Vref.

Le circuit d'aiguillage est commandé:

- d'une part par les sorties du compteur 16, plus précisément par celles qui servent à établir la conversion du contenu du compteur en une quantité analogique proportionnelle à ce contenu; en fait on peut n'utiliser que n sorties de poids le plus fort du compteur.

- d'autre part, par un circuit de commande de commutation, non représenté, qui établit des signaux périodiques à la fréquence de comptage f du compteur 16, selon un cycle à plusieurs phases qui est représenté sur la figure 4. Pour l'essentiel, deux signaux en créneaux périodiques $\varnothing1$ et $\varnothing2$ de même fréquence sont établis. $\varnothing1$ et $\varnothing2$ passent au niveau logique 1 sensiblement en même temps et $\varnothing2$ reste à 1 plus longtemps que $\varnothing1$; un signal $\varnothing'1$ est également prévu, identique à $\varnothing1$ mais repassant à zéro légèrement avant $\varnothing1$.

- et enfin par les sorties de la bascule 22 de mémorisation du signe de V1, pour modifier les aiguillages selon le signe de V1.

Le circuit d'aiguillage 24 comprend un certain nombre de commutateurs d'aiguillage et de portes de commande (portes OU et OU-Exclusif). Par convention, sur la figure 3, les commutateurs se tournent vers la gauche de la figure lorsque le signal qui les commande est au niveau logique 1 et vers la droite lorsque le signal qui les commande est au niveau zéro.

Les divers commutateurs du circuit d'aiguillage sont les suivants: un premier commutateur I1, commandé par le signal $\varnothing'1$, permet de mettre à la masse la première armature des capacités C1 à $C_n$ ($\varnothing'1 = 1$) ou de la laisser en haute impédance ($\varnothing'1 = 0$).

Un commutateur I2, commandé par le signal $\varnothing1$, permet d'appliquer à un point intermédiaire G du circuit soit le signal d'entrée V1 ($\varnothing1 = 1$), soit le potentiel de masse ($\varnothing1 = 0$).

Une série de commutateurs J1 à $J_n$, permettent de relier individuellement la seconde armature de chaque capacité (C1 à $C_n$ respectivement), soit au point G soit au potentiel de référence Vréf. Chaque commutateur J1 à $J_n$ est commandé par la sortie d'une porte OU respective K1 à $K_n$ dont une entrée reçoit le signal $\varnothing2$ et l'autre reçoit la sortie d'une porte OU-Exclusif respective L1 à $L_n$. Cette porte OU-Exclusif possède une entrée reliée à la sortie Q de la bascule 22 et une autre entrée reliée à une sortie respective prise parmi les n sorties de poids fort du compteur/décompteur 16.

Ainsi, chaque capacité commutée peut être commandée par une sortie respective du compteur. Les valeurs des capacités sont pondérées selon une progression binaire qui correspond à la pondération des n sorties de poids fort du compteur, et une capacité de poids binaire déterminé est commandée par la sortie du compteur de même poids binaire.

La capacité C1 est commandée par la sortie de poids le plus faible du compteur.

La capacité $C_n$, commandée par la sortie de poids le plus fort du compteur, a pour valeur $2^{n-1}C1$; la capacité $C_{n-1}$, a pour valeur $2^{n-2}C1$ etc...

On a prévu en outre une capacité C'1 de même valeur que C1, directement reliée, sans commutateur, entre l'entrée inverseuse du comparateur 12 et le point G. Enfin, une capacité supplémentaire $C_{n+1}$, de valeur égale à la somme des capacités C1 à $C_n$ donc $(2^n-1)C1$ a une première armature reliée comme les autres capacités (C1 à $C_n$ et C'1) à l'entrée inverseuse du comparateur 12 et à sa deuxième armature reliée à un commutateur supplémentaire $J_{n+1}$ qui permet de la relier soit au potentiel de référence Vréf soit au point G. Ce commutateur est commandé par une porte OU $K_{n+1}$ dont une entrée reçoit le signal $\varnothing2$ et l'autre reçoit la sortie Q de la bascule 22 de mémorisation du signe de V1.

Pour terminer la description de la figure 3, on peut signaler que le signal d'horloge appliqué au compteur-décompteur pour l'incrémenter ou le décrémenter est issu d'une porte OU 24 recevant sur une entrée le signal $\varnothing1$ et sur l'autre entrée une sortie de débordement C0 du compteur. Cette sortie de débordement C0 passe à 1 si le contenu du compteur atteint son maximum en comptage ou son minimum en décomptage. Le compteur s'incrémente ou se décrémente lors des fronts de montée du signal $\varnothing1$, avec interdiction de dépassement du maximum ou du minimum.

Enfin, la bascule 22 possède une entrée de déclenchement recevant le signal $\varnothing2$ inversé par un inverseur, de sorte que le basculement éventuel (selon l'état de la sortie du comparateur) se produit sur les fronts de descente des créneaux $\varnothing2$.

Le fonctionnement détaillé du circuit de la figure 3 va maintenant être décrit.

A chaque période définie par le circuit de commande de commutation on distingue trois phases principales: une phase de précharge dans laquelle ⌀1 et ⌀2 sont à 1; une phase de détermination du signe de V1 pendant laquelle ⌀1 est à 0 et ⌀2 toujours à 1, et une phase de comparaison pendant laquelle à la fois ⌀2 sont à 0.

a) phase de précharge
- les secondes armatures des capacités $C_1$ à $C_n$ sont reliées au point G par les commutateurs J1 à $J_n$ car ⌀2 = 1.
- le point G reçoit lui-même la tension d'entrée V1 par le commutateur I2 car ⌀1 = 1.
- la seconde armature de la capacité $C_{n+1}$ est reliée à Vréf car ⌀2 = 1.
- enfin, la première armature de toutes les capacités $C_1$ à $C_n$, C'1 et $C'_{n+1}$ est reliée à la masse par le commutateur I1 car ⌀1 = ⌀'1 = 1.
Les capacités $C_1$ à $C_n$ et C'1 prennent des charges respectives $C_1$ V1, $C_2$ V1, $C_n$ V1 et C'1 V1.
La capacité $C_{n+1}$ prend une charge $C_{n+1}$ Vréf.
Au total, la charge globale présente au point commun reliant les premières armatures de toutes ces capacités est
- $C_1V_1$ - $C_2V_1$...- $C_nV_1$ - C'1V1 - $C_{n+1}$ Vréf.
Juste avant la fin de la phase de précharge, c'est-à-dire juste avant que ⌀1 passe à zéro, le signal ⌀'1 passe à zéro, ouvrant le commutateur I1 et isolant cette charge globale sur l'entrée (haute impédance) du comparateur I2.

b) phase de détermination du signe de V1.
Les commutateurs sont dans la même position qu'à la phase de précharge, sauf I1 qui est ouvert et I2 qui change d'état et relie le point G à la masse.
Toutes les secondes armatures des capacités étant alors à la masse, sauf $C_{n+1}$ qui reste à Vréf, les premières armatures passent à un potentiel -V1 du fait de la charge stockée et isolée sur les premières armatures; ce potentiel -V1 apparaît donc sur l'entrée inverseuse du comparateur I2.
Le comparateur I2 fournit alors un état logique 1 si V1 est positif et 0 si V1 est négatif.
Cet état subsiste jusqu'au front descendant de ⌀2 qui définit la fin de la phase de détermination du signe. Sur ce front descendant, la sortie Q de la bascule 22 prend l'état imposé par la sortie du comparateur et la sortie $\bar{Q}$ prend l'état complémentaire. L'état de la bascule se maintient alors pendant toute une période.

c) Phase de comparaison
Dans tous les cas l'interrupteur I1 maintient en haute impédance (isolement vis-à-vis de tout courant continu l'entrée du comparateur I2 et les premières armatures de capacités qui y sont reliées). Le commutateur I2 maintient le point G à la masse.
Il faut distinguer alors deux cas selon que V1 est positif ou négatif pendant le cycle de commutation considéré.
1°/V1 est positif
Le commutateur $J_{n+1}$ reste dans sa position initiale car la porte OU $K_{n+1}$ lui transmet la sortie Q = 1 de la bascule 22.
Les portes OU-Exclusif L1 à $L_n$ recevant un état 1 de la bascule 22 inversent alors les états des n sorties de poids fort du compteur/décompteur 16.
Les portes OU simples K1 à $K_n$ transmettent ces états inversés pour servir de commande aux commutateurs J1 à $J_n$.
Ainsi, si la sortie de poids n est à 1, le commutateur $J_n$ basculera pour relier la seconde armature de la capacité $C_n$ à Vréf. Inversement, si cette sortie est 0, le commutateur $J_n$ ne basculera pas et laissera la seconde armature de la capacité $C_n$ reliée au point G donc à la masse. De même, la seconde armature de chaque capacité $C_1$ à $C_n$ est portée à Vréf si la sortie de poids correspondant est à 1 et est portée à 0 si cette sortie est à 0.

Il en résulte que le potentiel commun des premières armatures des capacités commutées va prendre une valeur V telle que la somme des charges des différentes capacités reliées à l'entréee du comparateur équilibre la charge initialement stockée, dont on rappelle qu'elle est égale à: $-C_1V_1$ - $C_2V_1$ - .... - $C_nV_1$ - C'1V1 - $C_{n+1}$ Vréf   (1)
Pour calculer la somme des charges des capacités lorsqu'un potentiel V est présent sur la première armature, il faut se rappeler que les capacités ont des valeurs pondérées selon le poids des sorties de compteur qui commandent maintenant l'application individuelle de Vréf ou 0 à ces capacités ($C_n = 2^{n-1} C_1$; $C_{n+1} = 2^{n-2}C_1$ etc...).
Cette somme de charges est alors, si N est le contenu du compteur, le mot "contenu" étant ici le contenu présent sur les sorties de poids fort uniquement : $(C_1 +...+ C_n)$ V - N Vréf $C_1$ + VC'1 + (V - Vréf) $C_{n+1}$,  (2)
L'égalité des termes (1) et (2) entraîne, en rappelant que $C_{n+1}$ = $C_1$ +...+ $C_n$ = $2^{(n-1)}C_1$ et que C'1 = $C_1$:
$V(2^{n+1} - 1)C_1 = (N Vréf - V1.2^n)C_1$ ou

$$V = \frac{-2^n}{2^{n+1} - 1} \left( V1 - \frac{N\,V\text{réf}}{2^n} \right) \qquad (3)$$

Le potentiel V qui s'établit sur l'entrée du comparateur représente donc un signal d'écart tel que défini précédemment, à savoir un signal représentant l'écart entre le signal d'entrée (V1) et une quantité proportionnelle au contenu N du compteur ($N\,V\text{réf}/2^n$).

Le comparateur 12 fournit un état logique 1 si le signal d'écart V1 -

$$V1 - \frac{N\,V\text{réf}}{2^n}$$

est positif, et un état 0 si ce signal est négatif. Cet état définit le sens de comptage du compteur : comptage si $NV\text{réf}/2^n$ est inférieur à V1, décomptage dans le cas contraire.

L'incrémentation ou la décrémentation du compteur avec le sens ainsi défini se produit sur le front de montée du signal $\varnothing 1$, c'est-dire à la fin de la phase de comparaison et au début de la phase de précharge de la période suivant.

2°/V1 est négatif pendant la période considérée

Il faut alors comparer la quantité $NV\text{réf}/2^n$ représentant le contenu du compteur à la valeur absolue de V1, c'est-à-dire à -V1.

Il faut donc établir un signal d'écart - V1 - $N\,V\text{réf}/2^n$, c'est-à-dire un potentiel V égal à

$$\frac{-2^n}{2^{n+1}-1} \left( - V1 - \frac{N\,V\text{réf}}{2^n} \right)$$

sur l'entrée négative du comparateur 12. Mais on peut aussi établir un potentiel

$$V = \frac{-2^n}{2^{n+1} - 1} \left( V1 + \frac{N\,V\text{réf}}{2^n} \right)$$

et inverser alors l'instruction de comptage ou décomptage donnée par la sortie du comparateur. C'est ce qu'on fait ici, comme on va le voir, l'inversion de l'instruction se faisant par la porte OU-Exclusif 20 commandée par la sortie $\overline{Q} = 1$ de la bascule 22.

En reprenant la démarche faite pour le calcul de V avec V1 positif, on a maintenant un basculement du commutateur $J_{N+1}$ vers la position où la capacité $C_{n+1}$ est reliée au point G donc à la masse.

Les portes OU-Exclusif L1 à $L_n$ n'inversent plus les états des n sorties du compteur. Ainsi, si la sortie de poids n est à 1, le commutateur $J_n$ ne basculera pas et laissera la seconde armature de la capacité $C_n$ reliée au point G donc à la masse. Inversement, si cette sortie est à zéro, le commutateur basculera pour relier la capacité $C_n$ à Vréf. De même pour les autres capacités C1 à $C_{n-1}$.

Le potentiel commun des premières armatures va prendre une valeur V telle que la somme des charges des différentes capacités équilibre la charge initialement stockée dont on rappelle qu'elle est égale à $-C1V1 - C2V1 - ... - C_nV1 - C'1\,V1 - C_{n+1}\,V\text{réf}$    (1)

Maintenant, la somme des charges des capacités est $(C1 + ... + C_n)\,V - (C1 + ... + C_n)V\text{réf} + N\,V\text{réf}\,C1 + VC'1 + VC_{n+1}$  (4)

L'égalité des termes 1 et 4 entraîne : $V(2^{n+1} - 1)\,C1 = - N\,V\text{réf}\,C1 - 2^n\,V1$ ou

$$V = \frac{-2^n}{2^{n+1} - 1} \cdot \left( V1 + \frac{N\,V\text{réf}}{2^n} \right) \qquad (5)$$

ce qui correspond bien à ce que l'on cherchait, à savoir l'établissement d'un signal d'écart représentant la différence entre la valeur redressée (- V1) du signal d'entrée V1 et du terme $N\,V\text{réf}/2^n$ proportionnel au contenu du compteur.

Il y aura encore, au moment du front de montée de $\varnothing 1$ incrémentation du compteur si - V1 est supérieure à $N\,V\text{réf}/2^n$ et décrémentation dans le cas contraire.

Comme dans le cas de la figure 1, le contenu du compteur va représenter le niveau moyen du signal d'entrée V1. Le bit de poids fort du compteur indique directement dans l'exemple considéré si ce niveau est supérieur ou inférieur à Vréf/2 puisque N passe à $2^{n-1}$ lorsque le bit de poids fort passe à 1 ; la capacité non commutée C'1 égale à C1 est d'ailleurs justement prévue ici pour permettre avec la plus grande exactitude cette utilisation simple de la sortie de poids fort de compteur. Sinon, plusieurs sorties peuvent être utilisées pour définir un seuil de niveau différent.

Bien entendu, plus la vitesse de croissance de $N$ Vréf/$2^n$ est lente, plus l'oscillation du contenu du compteur autour de la valeur moyenne détectée est faible, mais plus le temps d'établissement de cette valeur moyenne est long (ainsi d'ailleurs que le temps de retour à zéro en cas de disparition du signal d'entrée). Il faut donc adopter un compromis sur ce point.

Pour terminer, on peut indiquer une variante de réalisation de pseudo-redressement de la tension d'entrée dans un mode d'exécution à capacités commutées tel que celui de la figure 3 : si on dispose d'une source de tension de référence négative (- Vréf), on peut l'utiliser à la place de Vréf lorsque la bascule 22 indique un signe négatif de la tension d'entrée; on supprime alors la capacité $C_{n+1}$ et les portes OU-Exclusif L1 à $L_n$ qui ne deviennent plus nécessaires. On réalise alors de la même manière une comparaison de V1 à $N$ Vréf/$2^n$ lorsque V1 est positif et une comparaison de -V1 à $N$ Vréf/$2^n$ lorsque V1 est négatif.

## Revendications

1. Détecteur de niveau d'un signal analogique, comprenant:
   - un compteur/décompteur (16) dont les sorties binaires fournissent une indication du niveau du signal analogique,
   - un comparateur analogique (12) dont la sortie est reliée à une entrée de sens de comptage du compteur, le sens de comptage étant déterminé par l'état de la sortie du comparateur,
   - un moyen d'établissement d'un signal analogique d'écart (14, 24, C1...$C_n$), ce moyen étant relié aux sorties du compteur/décompteur et recevant par ailleurs le signal analogique à détecter, pour établir et appliquer à l'entrée du comparateur un signal d'écart (V4, V) représentant la différence entre le niveau de tension (V1) du signal analogique à détecter et une quantité ($N$ Vréf/$2^n$) proportionnelle au contenu (N) du compteur, et
   - un moyen d'établissement d'une fréquence de comptage (f) pour le compteur, cette fréquence étant telle que la durée de croissance du contenu (N) du compteur de zéro à sa valeur maximale soit largement supérieure à la période moyenne du signal analogique à détecter,

   caractérisé en ce que le moyen d'établissement du signal d'écart comporte un ensemble de capacités commutées, (C1, C2...$C_n$), un circuit de commande de commutation, une source de tension de référence (Vréf) et un circuit d'aiguillage (24), et en ce que
   - les capacités (C1 à $C_n$) ont des valeurs respectives pondérées selon les mêmes poids binaires que les sorties du compteur,
   - le circuit de commande de commutation établit des signaux de commande de commutation selon un cycle périodique de commutation à plusieurs phases, à la fréquence (f) de comptage du compteur,
   - le circuit d'aiguillage applique individuellement à chaque capacité soit le signal d'entrée (V1), soit la tension de référence (Vréf), soit un potentiel de masse; ce circuit est commandé par le circuit de commande de commutation et par les sorties du compteur,
   - le cycle de commutation comporte au moins une phase de précharge et une phase de comparaison,
   - dans la phase de précharge les capacités sont toutes chargées avec le signal d'entrée et les charges stockées sont isolées,
   - dans la phase de comparaison, le potentiel de référence ou un potentiel de masse est appliqué à une armature de chaque capacité, selon que la sortie de compteur ayant le même poids binaire que cette capacité a une valeur 0 ou 1, les autres armatures des capacités étant reliées à l'entrée du comparateur tout en conservant un isolement global de la somme des charges stockées pendant la phase de précharge.

2. Détecteur selon la revendication 1, caractérisé en ce que le circuit de commande de commutation établit à chaque période dudit cycle périodique de commutation une phase supplémentaire de détermination du signe du signal d'entrée, en ce qu'il est prévu une bascule (22) de mémorisation du signe déterminé, cette bascule ayant son entrée reliée à la sortie du comparateur, et en ce que le circuit d'aiguillage est également commandé par les sorties de la bascule pour établir un signal d'écart qui, lorsque le signe déterminé est négatif, représente la différence entre l'inverse du signal d'entrée et la quantité proportionnelle au contenu du compteur.

3. Détecteur selon la revendication 2, caractérisé en ce que, pendant la phase de détermination du signe, on applique à une armature de chaque capacité le potentiel de masse, les autres armatures étant reliées à l'entrée du comparateur, tout en conservant un isolement global de la somme des charges stockées sur les capacités pendant la phase de précharge.

4. Détecteur selon la revendication 3, caractérisé en ce qu'il est prévu des portes OU-Exclusif dont chacune reçoit sur une entrée la sortie de la bascule de mémorisation du signe (22) et sur son autre entrée une sortie du compteur (16) et dont les sorties sont appliquées aux bornes de commande de commutateurs du circuit d'aiguillage.

5. Détecteur selon la revendication 4, caractérisé en ce qu'il est prévu en outre une porte OU-Exclusif (20) dont une entrée reçoit la sortie du comparateur (12), dont l'autre entrée reçoit la sortie de la bascule de mémorisation du signe et dont la sortie est appliquée à l'entrée de sens de comptage du compteur (16).

6. Détecteur selon l'une des revendications 2 à 5, caractérisé en ce qu'une capacité supplémentaire ($C_{n+1}$) de valeur égale à la somme des autres est montée entre l'entrée du comparateur et un commutateur ($J_{n+1}$) commandé par la bascule de mémorisation du signe, et en ce que pendant la phase de précharge on applique à cette capacité le potentiel de référence, et pendant la phase de comparaison on lui applique soit le potentiel de référence soit le potentiel de masse selon que le signe déterminé est positif ou négatif.

**Claims**

1. An analog signal level detector comprising:
 – an up/down counter (16), the binary outputs of which provide an indication of the analog signal level,
 – an analog comparator (12), having an output connected to an up/down control input of the counter, the up or down direction being determined by the comparator output state,
 – means (14, 24, C1...Cn) for establishing a difference signal, said means being connected to the outputs of the up/down counter and also receiving the analog signal to be detected, for establishing and applying to the comparator input a difference signal (V4, V) representing the difference between the voltage level (V1) of the analog signal to be detected and a quantity (N Vref/2ⁿ) proportional to the content (N) of the counter, and
 – means for establishing a counting frequency (f) for the counter, said frequency being such that the duration of increase of the counter content (N) from zero to its maximum value significantly exceeds the mean period of the signal to be detected,
characterized in this that said means for establishing the difference signal comprises a group of switched capacitors (C1, C2...Cn), a switching control circuit, a reference voltage source (Vref) and a steering circuit (24), and in this that
 – the capacitors (C1–Cn) have respective weighted values in accordance with the same binary weights as the outputs of the counter,
 – the switching control circuit establishes the switching control signals in accordance with a periodic switching cycle with several phases at the counter counting frequency (f),
 – said steering circuit individually applies to each capacitor either said input signal (V1), or a reference voltage (Vref) or an earth potential; this circuit is controlled by the switching control circuit and by the counter outputs,
 – the switching cycle has at least one precharging phase and a comparison phase,
 – in the precharging phase, the capacitors are all charged with said input signal and thereafter the stored charges are isolated,
 – in the comparison phase, the reference potential or an earth potential is applied to one plate of each capacitor, depending on whether that counter output which has the same binary weight as said capacitor has a value 0 or 1, the other plate of each capacitor being connected to the comparator input, whilst retaining an overall isolation of the sum of the charges stored during the precharging phase.

2. A detector according to claim 1, characterized in this that the switching control circuit establishes at each period of the periodic switching cycle an additional phase for determining the sign of the analog signal, there is a latch (22) for storing the determined sign, said latch having an input connected to the comparator output, and the steeering circuit is also controlled by the latch outputs for establishing a difference signal which, when the determined sign is negative, represents the difference between the inverse of the input signal and said quantity proportional to the counter content.

3. A detector according to claim 2, characterized in this that, during the sign determination phase, one plate of each capacitor is connected to the earth potential, the other plate being connected to the comparator input, whilst retaining an overall isolation of the sum of the charges stored on the capacitors during the precharging phase.

4. A detector according to claim 3, wherein there are Exclusive-OR gates, each of which receives on one input the output of the sign storing latch (22) and on its other input an output of the counter (16), and the outputs of which are applied to the switch control terminals of the steering circuit.

5. A detector according to claim 4, wherein there is also an Exclusive-OR gate (20), one input of which receives the output of the comparator (12), the other input of which receives the output of the sign storing latch, and the output of which is applied to the up/down control input of said counter (16).

6. A detector according to any of claims 2 to 5, characterized in this that an additionnal capacitor ($C_{n+1}$) with a value equal to the sum of the others is connected between the comparator input and a switch ($J_{n+1}$) controlled by said sign storing latch and in this that, during the precharging phase, to said capacitor is applied the reference potential and, during the comparison phase, is applied thereto either the reference potential, or the earth potential, according to whether the determined sign is positive or negative.

**Patentansprüche**

1. Pegelsensor für ein analoges Signal, mit
- einem Vorwärts-/Rückwärtszähler (16), dessen binäre Ausgänge eine Angabe zum Pegel des analogen Signals liefern,
- einem Analog-Vergleicher (12), dessen Ausgang mit einem Eingang für die Zählrichtung des Zählers verbunden ist, wobei die Zählrichtung durch den Schaltzustand des Vergleicher-Ausgangs bestimmt ist,
- einer Einrichtung (14, 24, $C_1...C_n$) zur Erzeugung eines analogen Differenzsignals, die an die Ausgänge des Vorwärts-/Rückwärtszählers angeschlossen ist und im übrigen das festzustellende analoge Signal empfängt und dazu bestimmt ist, ein Differenzsignal (V4, V), das die Differenz zwischen dem Spannungsniveau (V1) des festzustellenden analogen Signals und einer dem Zählstand (N) des Zählers proportionalen Größe ($N VRef/2^n$) darstellt, zu erzeugen und an den Eingang des Vergleichers abzugeben, und
- einer Einrichtung zur Erzeugung einer Zählfrequenz (f) für den Zähler, wobei diese Frequenz so ist, daß die Zeit, in welcher der Zählerzählstand (N) von Null auf seinen Größtwert ansteigt, reichlich größer ist als die mittlere Periode des festzustellenden analogen Signals,
dadurch gekennzeichnet, daß die Einrichtung zur Erzeugung des Differenzsignals eine Gruppe zusammengeschalteter Kondensatoren (C1, C2, ... c$C_n$), eine Umschaltsteuerschaltung, eine Quelle für Referenzspannung (VRef) und eine Verteilerschaltung (24) umfaßt, und daß
- die Kondensatoren ($C_1$ bis $C_n$) nach denselben binären Wertigkeiten gewichtet sind wie die Zählerausgänge,
- die Umschaltsteuerschaltung Umschaltsteuersignale entsprechend einem mehrphasigen periodischen Umschaltzyklus mit der Zählfrequenz (f) des Zählers erzeugt,
- die Verteilerschaltung jedem Kondensator individuell entweder das Eingangssignal (V1), die Referenzspannung (VRef), oder ein Massepotential zuleitet, wobei diese Schaltung durch die Umschaltsteuerschaltung und die Zählerausgänge gesteuert wird,
- der Umschaltzyklus wenigstens eine Vorladephase und eine Vergleichsphase umfaßt,
- in der Vorladephase alle Kondensatoren mit dem Eingangssignal geladen werden und die gespeicherten Ladungen isoliert werden,
- in der Vergleichsphase das Referenzpotential oder ein Massepotential an eine Elektrode jedes Kondensators anlegt ist, je nachdem, ob der Ausgang des Zählers, der dieselbe binäre Wertigkeit wie dieser Kondensator hat, den Schaltwert 0 oder 1 hat, wobei die übrigen Elektroden der Kondensatoren unter Beibehaltung einer globalen Isolierung der Summe der während der Vorladephase gespeicherten Ladungen mit dem Eingang des Vergleichers verbunden sind.

2. Sensor nach Anspruch 1, dadurch gekennzeichnet, daß die Umschaltsteuerschaltung bei jeder Periode des genannten periodischen Umschaltzyklus eine zusätzliche Phase zur Bestimmung des Vorzeichens vom Eingangssignal erzeugt, daß eine Kippschaltung (22) zur Speicherung des ermittelten Signals vorgesehen ist, welche mit ihrem Eingang an den Ausgang des Vergleichers angeschlossen ist, und daß die Verteilerschaltung ebenfalls durch die Ausgänge der Kippschaltung gesteuert wird, derart, daß ein Differenzsignal erzeugt wird, welches bei negativem Vorzeichen des ermittelten Signals die Differenz zwischen dem inversen Eingangssignal und der dem Zählstand proportionalen Größe darstellt.

3. Sensor nach Anspruch 2, dadurch gekennzeichnet, daß während der Phase der Vorzeichenbestimmung an eine Elektrode jedes Kondensators das Massepotential angelegt wird, wobei die übrigen Elektroden unter Beibehaltung einer globalen Isolierung der auf den Kondensatoren während der Vorladephase gespeicherten Ladungen an den Eingang des Vergleichers angeschlossen sind.

4. Sensor nach Anspruch 3, dadurch gekennzeichnet, daß Exklusives-ODER-Glieder vorgesehen sind, von denen jedes an einem Eingang den Ausgang der Kippschaltung (22) zur Speicherung des Vorzeichens und an seinem anderen Eingang einen Ausgang des Zählers (16) empfängt und dessen Ausgänge den Umschaltsteueranschlüssen der Verteilerschaltung zugeführt werden.

5. Sensor nach Anspruch 4, dadurch gekennzeichnet, daß außerdem ein Exklusives-ODER-Glied (20) vorgesehen ist, von dem ein Eingang den Ausgang des Vergleichers (12), der andere Eingang den Ausgang der Kippschaltung für die Vorzeichenspeicherung empfängt und dessen Ausgang dem Eingang für die Zählrichtung des Zählers (16) zugeführt wird.

6. Sensor nach einem der Ansprüche 2 bis 5, dadurch gekennzeichnet, daß ein zusätzlicher Kondensator ($C_{n+1}$), der einen der Summe der übrigen gleichen Wert hat, zwischen dem Eingang des Vergleichers und einem von der Kippschaltung für die Vorzeichenspeicherung gesteuerten Schalter ($J_{n+1}$) angeordnet ist, und daß diesem Kondensator während der Vorladephase das Referenzpotential und während der Vergleichsphase entweder das Referenzpotential oder das Massepotential zugeführt wird, je nachdem, ob das ermittelte Vorzeichen positiv oder negativ ist.

Fig.3